# EUROPÄISCHE PATENTSCHRIFT

(11) **EP 3 223 592 B1**
(45) Veröffentlichungstag und Bekanntmachung des Hinweises auf die Patenterteilung: **08.05.2019**
(21) Anmeldenummer: 17000370.1
(22) Anmeldetag: 07.03.2017
(51) Int. Cl.: H05K 1/16, H02P 3/12

(54) **ELEKTRONISCHE STEUEREINHEIT ZUM BETRIEB EINES ELEKTROMOTORS MIT EINEM BREMSWIDERSTAND**
ELECTRONIC CONTROL UNIT FOR OPERATING AN ELECTRIC MOTOR WITH A BRAKE RESISTOR
UNITÉ DE COMMANDE ÉLECTRONIQUE DESTINÉE AU FONCTIONNEMENT D'UN MOTEUR ÉLECTRIQUE COMPRENANT UNE RÉSISTANCE DE FREINAGE

(30) Priorität: 16.03.2016 DE 102016003255
(43) Veröffentlichungstag der Anmeldung: 27.09.2017
(73) Patentinhaber: Andreas Stihl AG & Co. KG, 71336 Waiblingen (DE)
(72) Erfinder: Gurr, Kay-Steffen, 74078 Heilbronn (DE); Liebhard, Gernot, 71332 Waiblingen (DE); Lehmann, Lothar, 73776 Altbach (DE); Sämann, Rudolf, 72336 Balingen (DE)
(74) Vertreter: Wasmuth, Rolf

(56) Entgegenhaltungen:
- EP-A2- 1 791 246
- WO-A1-01/74703
- WO-A1-92/11679
- DE-A1- 10 352 653

## Beschreibung

Die Erfindung betrifft eine elektronische Steuereinheit zum Betrieb eines Elektromotors an einem Akkupack nach dem Oberbegriff des Anspruchs 1.

Elektronische Steuereinheiten zum Betrieb von Elektromotoren wie Gleichstrommotoren, EC-Motoren (elektronisch kommutierte Motoren) oder dgl. Elektromotoren sind bekannt.

Es ist auch bekannt, die Auslaufzeiten eines Elektromotors durch einen Bremskreis zu reduzieren, indem die generatorische Spannung des Elektromotors beim Auslaufen über einen Lastwiderstand kurzgeschlossen wird, wodurch ein elektromagnetisches Bremsmoment erzeugt wird. Durch die als Ohm'scher Bremswiderstand ausgebildete Last fließen hohe Lastströme, die im Bremswiderstand zu Wärme umgewandelt werden. Daher werden Bremswiderstände getrennt von der elektronischen Steuereinheit und deren elektronischen Bauelementen angeordnet und mit geeigneten großen Kühlkörpern versehen, um die im Bremsfall anfallende Wärmemenge abzuführen.

Aus der WO 01/74703 A1 ist eine Steuereinheit für einen Aufzugsmotor bekannt, der einen körperlich eigenständigen Bremswiderstand in einem Bremskreis zeigt, der zum Abbau der generatorischen Motorspannung über einen Bremsschalter einzuschalten ist.

Die WO 92/11679 A1 offenbart einen Akkupack, dessen Leistungsanschlüsse zur Vermeidung eines Überstroms im Kurzschlussfall eine Sicherung aufweisen, die als ohmscher Widerstand auf einer Platine ausgebildet ist. Die als Schmelzsicherung ausgebildete Sicherung wird bei hohen Strömen bestimmungsgemäß zerstört und unterbricht die elektrische Verbindung zwischen den Leistungsanschlüssen und dem Akkupack. Der Akkupack ist zerstört und muss ausgetauscht werden.

Der Erfindung liegt die Aufgabe zugrunde, den Montageaufwand einer elektronischen Steuereinheit mit einem Bremswiderstand in einem elektrischen Bremskreis zu reduzieren.

Die Aufgabe wird erfindungsgemäß nach den Merkmalen des Anspruchs 1 gelöst.

Die Aufnahmefläche der Platine dient einerseits der Anordnung der elektronischen Bauelemente und andererseits der Aufnahme des Bremswiderstandes. Da der Bremswiderstand bestimmungsgemäß als ohmsche Last zum Abbau einer generatorischen Spannung des auslaufenden Elektromotors vorgesehen ist, ist er thermisch stark belastet. Die Platine der elektronischen Steuereinheit ist räumlich unterteilt. In einem ersten Flächenbereich sind die elektronischen Bauelemente der Steuereinheit angeordnet, die zum Steuern des Elektromotors im Betrieb notwendig sind. In einem zweiten Flächenbereich der Platine ist erfindungsgemäß der Bremswiderstand vorgesehen, wobei der Bremswiderstand in besonderer Weise als auf der Platine ausgebildete Leiterbahn gestaltet ist.

Durch die Anordnung des Bremswiderstandes auf der Platine der Steuereinheit kann der schaltungstechnische Aufwand der Gesamtanordnung verringert werden. Körperliche Drahtverbindungen mit einem außerhalb der Steuereinheit angeordneten Bremswiderstand entfallen.

In vorteilhafter Ausbildung der Flächenbereiche ist vorgesehen, den zweiten Flächenbereich zur Aufnahme des Bremswiderstandes außerhalb des ersten Flächenbereiches der elektronischen Bauelemente vorzusehen. Vorteilhaft erstreckt sich der zweite Flächenbereich entlang zumindest einer ersten Kante der Platine, insbesondere entlang einer Längskante der Platine. Es kann zweckmäßig sein, wenn sich die Leiterbahn des Bremswiderstandes über zwei Kanten entlang der Platine erstreckt. Schließen die beiden Kanten der Platine unmittelbar aneinander an, so bildet der zweiten Flächenbereich in Draufsicht auf die Flachseite der Platine die Form eines L.

Der zweite Flächenbereich weist zwei einander mit Abstand gegenüberliegende Ränder auf, wobei die Leiterbahn zur Bildung des Bremswiderstandes zwischen diesen Rändern hin- und hergeführt ist. So kann der Bremswiderstand als mehrfach gewundene Kurvenbahn ausgebildet werden.

In einer vorteilhaften Ausführungsform der Erfindung ist die Kurvenbahn der Leiterbahn des Bremswiderstandes als Mäander ausgeführt.

Es kann zweckmäßig sein, die Leiterbahn des Bremswiderstandes auf nur einer Flachseite der Platine auszubilden. Wird die Platine durchkontaktiert, so können die Leiterbahnen zur elektrischen Verbindung der Bauelemente auf der gegenüberliegenden Platinenseite ausgebildet werden. Bei einer durchkontaktierten Platine ist der Anschluss des Bremswiderstandes an die Anschlussleitungen des Elektromotors einfach ausführbar.

In vorteilhafter Weise wird die Platine der Steuereinheit mit einer Vergussmasse vergossen. Die Vergussmasse steht in unmittelbar wärmeleitendem Kontakt mit der Leiterbahn des Bremswiderstandes. Trotz der relativ flachen Ausbildung des Bremswiderstandes als Leiterbahn wird über die Vergussmasse eine gute Wärmeableitung erzielt, so dass eine unzulässige Temperaturerhöhung im Umfeld des Bremswiderstandes vermieden ist.

Der Verdrahtungsaufwand zur Ausbildung des Bremskreises kann weiter reduziert werden, indem der Bremsschalter auf der Platine angeordnet ist. Wird der Bremsschalter auf der Platine angeordnet, können die elektrischen Verbindungen zum Bremswiderstand ebenso wie die elektrischen Verbindungen zum Motor als Leiterbahnen auf der Platine ausgebildet werden.

Die Platine besteht aus einem Verbundwerkstoff, insbesondere aus einem Epoxidharz und einem Glasfasergewebe. Ein derartiger Verbundwerkstoff wird schwer entflammbar ausgeführt, wozu entsprechende chemische Stoffe zugesetzt werden.

Das Material der Vergussmasse ist ein Kunstharz, insbesondere ein Polyurethan.

Weitere Merkmale der Erfindung ergeben sich aus den weiteren Ansprüchen, der Beschreibung und der Zeichnung, in der nachfolgend im Einzelnen beschriebene Ausführungsbeispiele der Erfindung dargestellt sind. Es zeigen:
- Fig. 1: ein schematisches Schaltbild einer Schaltung zum Betrieb eines Elektromotors an einem Akkupack,
- Fig. 2: eine Draufsicht auf eine Flachseite der Platine einer Steuereinheit,
- Fig. 3: einen Schnitt durch die Platine der elektronischen Steuereinheit längs der Line III-III in Fig. 2.

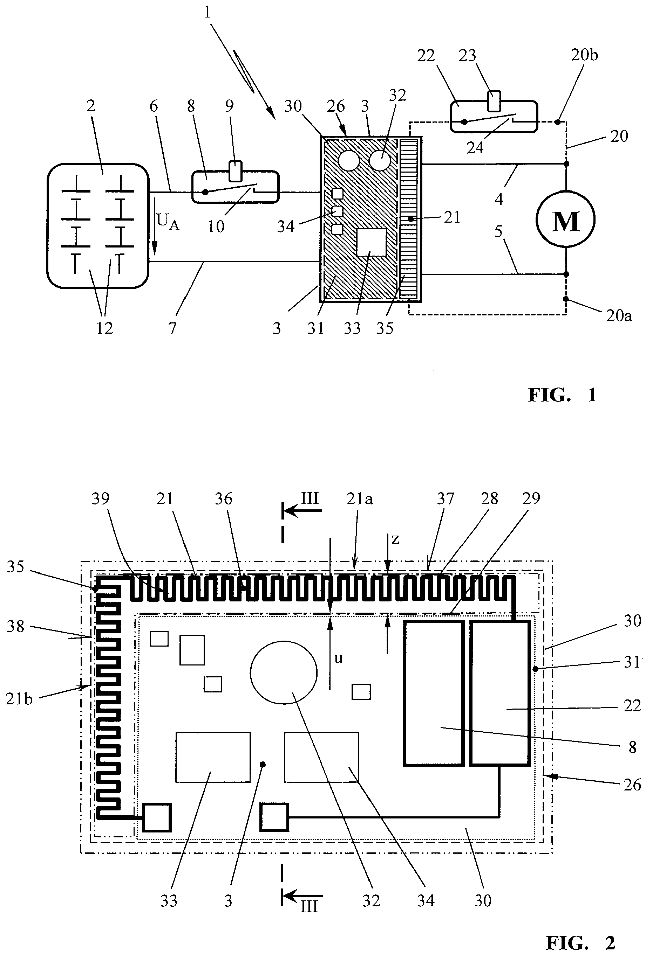

Fig. 1 zeigt in schematischer Darstellung eine Schaltung 1 mit einer elektronischen Steuereinheit 3 zum Betrieb eines Elektromotors M.

Im gezeigten Ausführungsbeispiel wird der Elektromotor M, der vorzugsweise als Gleichstrommotor ausgebildet ist, aus einem Akkupack 2 betrieben. Es kann vorteilhaft sein, anstelle des Akkupacks 2 eine Netzleitung zur Verbindung mit einem Spannungsnetz vorzusehen.

Der Akkupack 2 kann aus einer Vielzahl von Einzelzellen 12 bestehen, die in geeigneter Weise zur Bereitstellung einer Akkuspannung U_{A} zusammengeschaltet werden, beispielsweise in Reihenschaltung und/oder in Parallelschaltung. Der Akkupack 2 kann alternativ auch eine Einzelzelle sein.

Der Elektromotor M wird über die elektronische Steuereinheit 3 betrieben. Hierzu ist der Elektromotor M über Anschlussleitungen 4, 5 mit der Steuereinheit 3 verbunden. Die Steuereinheit 3 steht über Versorgungsleitungen 6, 7 mit dem Akkupack 2 in Verbindung. Zum Ein- bzw. Ausschalten der Spannungsversorgung der Steuereinheit 3 und des Elektromotors M ist ein Betriebsschalter 8 vorgesehen. Der Betriebsschalter 8 liegt in der Versorgungsleitung 6 zwischen der Steuereinheit 3 und dem Akkupack 2 und öffnet oder schließt einen elektrischen Kontakt 10.

Wird der Betätigungsstift 9 des Betriebsschalters 8 niedergedrückt, schließt der Kontakt 10, und die Betriebsspannung UA des Akkupacks 2 liegt an der Steuereinheit 3 an. Zur Inbetriebnahme des Elektromotors M wird dieser von der Steuereinheit 3 angesteuert.

Der Elektromotor M ist ferner mit einem elektrischen Bremskreis 20 versehen, der aus einem Bremswiderstand 21 und einem Bremsschalter 22 besteht. Der Bremskreis 20 verbindet die Anschlussleitungen 4 und 5 über den Bremswiderstand 21 miteinander. Zweckmäßig wird bei Öffnen des elektrischen Kontaktes 10 des Betriebsschalters 8 der Betätigungsstift 23 des Bremsschalters 22 niedergedrückt, so dass der Bremskontakt 24 geschlossen und die Anschlüsse des Elektromotors M über den Bremswiderstand 21 kurzgeschlossen sind. Die generatorische Spannung des auslaufenden Elektromotors M wird über den Bremswiderstand 21 als elektrische Last abgebaut; der auslaufende Elektromotor M wird aufgrund des im Bremskreis 20 fließenden Laststroms gebremst.

Die elektronische Steuereinheit 3 zum Betrieb des Elektromotors M ist zweckmäßig auf einer Platine 30 angeordnet, die gemäß der Erfindung aufgeteilt ist in einen ersten Flächenbereich 31 zur Aufnahme von elektronischen Bauelementen 32, 33, 34 der Steuereinheit 3 und einen zweiten Flächenbereich 35 zur Aufnahme des Bremswiderstandes 21 des Bremskreises 20. Wie insbesondere Fig. 2 zeigt, ist der Bremswiderstand 21 als auf der Platine 30 ausgebildete Leiterbahn 36 ausgebildet. Diese Leiterbahn 36 wird - ebenso wie weitere Leiterbahnen auf der Platine 30 - durch an sich bekannte Fertigungsverfahren erstellt, so z. B. durch Ätzen.

Die Aufnahmefläche 26 der Platine 30 - im Ausführungsbeispiel die Gesamtfläche einer Platinenseite 14 bzw. 15 - setzt sich zusammen aus dem ersten Flächenbereich 31 und dem zweiten Flächenbereich 35. Es ist vorgesehen, dass der zweite Flächenbereich 35 außerhalb des ersten Flächenbereichs 31 liegt. Dabei können die Flächenbereiche 31, 35 mit einem Abstand u voneinander angeordnet sein. Der gewählte Abstand u ist abhängig von der auftretenden Betriebsspannung und/oder von der auftretenden maximalen Temperatur des Bremswiderstandes 21 im Bremsfall. Der Abstand u wird derart gewählt, dass weder ein elektrischer Überschlag aus dem ersten Flächenbereich 31 in den zweiten Flächenbereich 35 noch eine unzulässige Temperatur für elektronische Bauelemente 32, 33, 34 im ersten Flächenbereich 31 auftreten kann.

Wie die Figuren 1 und 2 zeigen, erstreckt sich der zweite Flächenbereich 35 zur Aufnahme des Bremswiderstandes 21 entlang zumindest einer ersten Kante 37 der Platine 30. Im Ausführungsbeispiel ist die Platine 30 in Draufsicht auf eine Flachseite 14 bzw. 15 gemäß Fig. 2 in der Form eines Rechteckes ausgebildet. Eine erste Kante 37 bildet eine Längskante der Platine 30 und eine andere, zweite Kante 38 eine Querkante der Platine 30. Die erste Kante 37 und die zweite Kante 38 bilden vorteilhaft jeweils eine Außenkante der Platine 30. Eine Außenkante begrenzt die Platine 30 körperlich in ihrer Erstreckung.

Im Ausführungsbeispiel nach Fig. 2 erstreckt sich der Bremswiderstand 21 über die erste Kante 37 und die zweite Kante 38 der Platine 30. Wie die Draufsicht nach Fig. 2 zeigt, besteht der Bremswiderstand 21 aus einem ersten Widerstandsabschnitt 21a, der sich längs der längeren, ersten Kante 37 der Platine 30 erstreckt. Ein zweiter Widerstandsabschnitt 21b erstreckt sich längs der kürzeren zweiten Kante 38 der Platine 30. Wie die Figuren 1 und 2 zeigen, besteht die Platine 30 in der Draufsicht aus einer etwa rechteckförmigen Platte mit der längeren ersten Kante 37 und der kürzeren zweiten Kante 38. Eine andere geometrische Form der Platine 30 kann zweckmäßig sein, z. B. eine quadratische Form.

Der die Form eines Randstreifens aufweisende zweite Flächenbereich 35 des Bremswiderstandes 21 weist Ränder 28, 29 auf, die vorteilhaft mit einem Abstand z voneinander beabstandet sind und sich insbesondere längs der ersten, längeren Kante 37 der Platine 30 erstrecken. Die Ränder 28, 29 begrenzen - zumindest im Bereich des Widerstandsabschnitts 21a - den zweiten Flächenbereich 35.

Wie Fig. 2 zeigt, verläuft die Leiterbahn 36 des Bremswiderstandes 21 zwischen den einander mit dem Abstand z gegenüberliegenden Rändern 28 und 29 hin und her. Dabei kann die Leiterbahn 36 als mehrfach gewundene Kurvenbahn 39 gestaltet sein. Bevorzugt ist die Kurvenbahn des Bremswiderstandes 21 als Mäander ausgeführt.

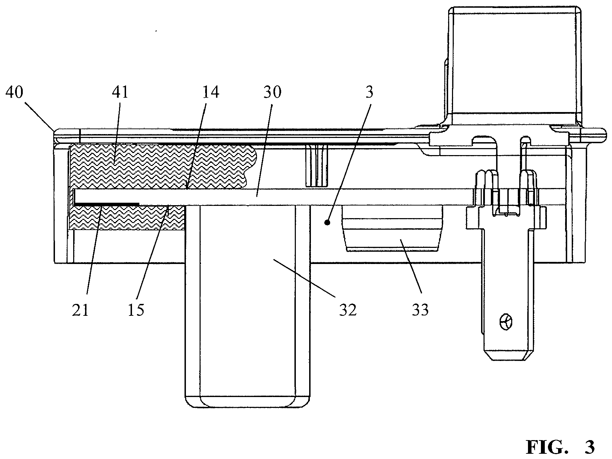

Die Platine 30 kann eine durchkontaktierte Platine sein, so dass sowohl auf der einen Flachseite der Platine 30 als auch auf der anderen Flachseite der Platine30 elektronische Bauelemente 32, 33, 34 angeordnet werden können. Die Leiterbahn 36 des Bremswiderstandes 21 ist zweckmäßig auf nur einer Flachseite 14 der Platine 30 ausgebildet; es kann zweckmäßig sein, auf der einen Flachseite 14 der Platine 30 einen ersten Bremswiderstand 21 und auf der anderen Flachseite 15 der Platine 30 einen zweiten Bremswiderstand 21' anzuordnen, wie dies in Fig. 3 schematisch angedeutet ist.

Die Platine 30 der elektronischen Steuereinheit 3 ist zweckmäßig in einem wannenförmigen Aufnahmegehäuse 40 gehalten, wobei die Platine 30 der Steuereinheit mit einer Vergussmasse 41 vergossen ist. Die Vergussmasse 41 besteht aus einem elektrisch isolierenden, wärmeleitenden Material, beispielsweise aus Polyurethan (PU). Durch das Vergießen steht die Leiterbahn 36 des Bremswiderstandes 21 in unmittelbar wärmeleitendem Kontakt mit der Vergussmasse 41.

Das Material der Platine 30 ist beispielsweise ein Verbundwerkstoff aus Epoxidharz und Glasfasergewebe.

Durch die räumliche Anordnung des Bremswiderstandes 21 auf der Platine 30 besteht die Möglichkeit, den Anschluss des Bremswiderstandes 21 an den Motor M auf der Platine 30 auszubilden. Dadurch kann der in Fig. 1 mit 20a bezeichnete Verdrahtungszweig entfallen; lediglich der Verdrahtungszweig 20b zum elektrischen Anschluss des Bremsschalters 22 ist getrennt von der Platine 30 erforderlich. Der Bremsschalter 22 liegt außerhalb der Steuereinheit 3. Der Bremsschalter 22 liegt räumlich neben der Steuereinheit 3, wie die Draufsicht nach Figur 2 zeigt.

Bei einem auf der Platine 30 angeordneten Bremsschalter 22, wie dies in Fig. 2 dargestellt ist, entfällt der elektrische Verdrahtungsaufwand für den Bremskreis 20. Der Bremswiderstand 21 sowie die elektrischen Verbindungen des Bremskreises 20 und zum Bremsschalter 22 können auf der Platine 30 bevorzugt als Leiterbahnen ausgebildet sein.

## Patentansprüche

1. Elektronische Steuereinheit zum Betrieb eines Elektromotors (M) an einem Akkupack (2), bestehend aus elektronischen Bauelementen (32, 33, 34) zur Ansteuerung des Elektromotors (M), und mit einem elektrischen Bremskreis (20) mit einem Bremswiderstand (21) als elektrische Last zum Abbau einer generatorischen Spannung des auslaufenden Elektromotors (M) über den Bremswiderstand (21), sowie mit einem Bremsschalter (22) zum Einschalten des Bremskreises (20),
**dadurch gekennzeichnet, dass** eine Platine (30) mit einer Aufnahmefläche (26) für die elektronischen Bauelemente (32, 33, 34) und den Bremswiderstand (21) vorgesehen ist, wobei die Aufnahmefläche (26) der Platine (30) räumlich aufgeteilt ist in einen ersten Flächenbereich (31) zur Aufnahme der elektronischen Bauelemente (32, 33, 34) und einen zweiten Flächenbereich (35) zur Aufnahme des Bremswiderstandes (21), und wobei der Bremswiderstand (21) als auf der Platine (30) ausgebildete Leiterbahn (36) gestaltet ist.

2. Steuereinheit nach Anspruch 1,
**dadurch gekennzeichnet, dass** sich der zweite Flächenbereich (35) außerhalb des ersten Flächenbereichs (31) entlang zumindest einer ersten Kante (37) der Platine (30) erstreckt.

3. Steuereinheit nach Anspruch 2,
**dadurch gekennzeichnet, dass** sich die Leiterbahn (36) des Bremswiderstandes (21) über zwei Kanten (37, 38) der Platine (30) erstreckt.

4. Steuereinheit nach einem der Ansprüche 1 bis 3,
**dadurch gekennzeichnet, dass** der zweite Flächenbereich (35) zwei mit Abstand (z) einander gegenüberliegende Ränder (28, 29) aufweist, und dass die Leiterbahn (36) des Bremswiderstandes (21) zwischen den Rändern (28, 29) hin- und hergeführt ist.

5. Steuereinheit nach einem der Ansprüche 1 bis 4,
**dadurch gekennzeichnet, dass** die Leiterbahn (36) des Bremswiderstandes (21) als mehrfach gewundene Kurvenbahn (39) ausgebildet ist.

6. Steuereinheit nach Anspruch 5,
**dadurch gekennzeichnet, dass** die Leiterbahn (36) des Bremswiderstandes (21) als Mäander ausgeführt ist.

7. Steuereinheit nach einem der Ansprüche 1 bis 6,
**dadurch gekennzeichnet, dass** die Leiterbahn (36) des Bremswiderstandes (21) auf nur einer Flachseite (14, 15) der Platine (30) ausgebildet ist.

8. Steuereinheit nach einem der Ansprüche 1 bis 7,
**dadurch gekennzeichnet, dass** die Platine (30) der Steuereinheit (3) mit einer Vergussmasse (41) vergossen ist und die Leiterbahn (36) des Bremswiderstandes (21) in unmittelbar wärmeleitendem Kontakt mit der Vergussmasse (41) steht.

9. Steuereinheit nach einem der Ansprüche 1 bis 8,
**dadurch gekennzeichnet, dass** der Bremsschalter (22) auf der Platine (30) angeordnet ist.

10. Steuereinheit nach einem der Ansprüche 1 bis 9,
**dadurch gekennzeichnet, dass** die Platine (30) aus einem Verbundwerkstoff aus Epoxidharz und einem Glasfasergewebe besteht.

11. Steuereinheit nach einem der Ansprüche 1 bis 10,
**dadurch gekennzeichnet, dass** die Vergussmasse (41) aus einem Polyurethan besteht.

## Claims

1. Electronic control unit for operating an electric motor (M) on a battery pack (2), consisting of electronic components (32, 33, 34) for controlling the electric motor (M) and with an electric brake circuit (20) with a brake resistor (21) as electric load for reducing a generator voltage of the coasting-down electric motor (M) via the brake resistor (21), and with a brake switch (22) for switching on the brake circuit (20),
**characterised in that** a printed circuit board (30) with a location surface (26) for the electronic components (32, 33, 34) and the brake resistor (21) is provided, wherein the location surface (26) of the printed circuit board (30) is spatially divided into a first surface region (31) for the accommodation of the electronic components (32, 33, 34) and a second surface region (35) for the accommodation of the brake resistor (21), and wherein the brake resistor (21) is designed as a conductor track (36) formed on the printed circuit board (30).

2. Control unit according to claim 1,
**characterised in that** the second surface region (35) extends outside the first surface region (31) along at least one first edge (37) of the printed circuit board (30).

3. Control unit according to claim 2,
**characterised in that** the conductor track (36) of the brake resistor (21) extends over two edges (37, 38) of the printed circuit board (30).

4. Control unit according to any of claims 1 to 3,
**characterised in that** the second surface region (35) has two edges (28, 29) located opposite each other at a distance (z), and **in that** the conductor track (36) of the brake resistor (21) is guided to and fro between the edges (28, 29).

5. Control unit according to any of claims 1 to 4,
**characterised in that** the conductor track (36) of the brake resistor (21) is designed as a multiply-wound curved track (39).

6. Control unit according to claim 5,
**characterised in that** the conductor track (36) of the brake resistor (21) is designed as a meander.

7. Control unit according to any of claims 1 to 6,
**characterised in that** the conductor track (36) of the brake resistor (21) is formed on only one flat side (14, 15) of the printed circuit board (30).

8. Control unit according to any of claims 1 to 7,
**characterised in that** the printed circuit board (30) of the control unit (3) is potted with a potting compound (41) and the conductor track (36) of the brake resistor (21) is in direct heat-conducting contact with the potting compound (41).

9. Control unit according to any of claims 1 to 8,
**characterised in that** the brake switch (22) is located on the printed circuit board (30).

10. Control unit according to any of claims 1 to 9,
**characterised in that** the printed circuit board (30) consists of a composite material made of epoxy resin and glass fibre fabric.

11. Control unit according to any of claims 1 to 10,
**characterised in that** the potting compound (41) consists of a polyurethane.

## Revendications

1. Unité de commande électronique pour le fonctionnement d'un moteur électrique (M) sur une batterie (2), composée de composants électroniques (32, 33, 34) pour commander le moteur électrique (M), et avec un circuit de freinage électrique (20) avec une résistance de freinage (21) comme charge électrique pour supprimer une tension génératrice du moteur électrique (M) sur son erre par l'intermédiaire de la résistance de freinage (21), et avec un commutateur de frein (22) pour mettre en marche le circuit de freinage (20),
**caractérisée en ce qu'**il est prévu une platine (30) avec une surface de réception (26) pour les composants électroniques (32, 33, 34) et pour la résistance de freinage (21), dans laquelle la surface de réception (26) de la platine (30) est divisée spatialement en une première zone de surface (31) pour recevoir les composants électroniques (32, 33, 34) et une seconde zone de surface (35) pour recevoir la résistance de freinage (21), et la résistance de freinage (21) est conçue comme une piste conductrice (36) formée sur la platine (30).

2. Unité de commande selon la revendication 1,
**caractérisée en ce que** la seconde zone de surface (35) s'étend en dehors de la première zone de surface (31), le long d'au moins une première arête (37) de la platine (30).

3. Unité de commande selon la revendication 2,
**caractérisée en ce que** la piste conductrice (36) de la résistance de freinage (21) s'étend sur deux arêtes (37, 38) de la platine (30).

4. Unité de commande selon l'une des revendications 1 à 3,
**caractérisée en ce que** la seconde zone de surface (35) présente deux bords (28, 29) opposés avec un écartement (z), et **en ce que** la piste conductrice (36) de la résistance de freinage (21) va et vient d'un bord à l'autre (28, 29).

5. Unité de commande selon l'une des revendications 1 à 4,
**caractérisée en ce que** la piste conductrice (36) de la résistance de freinage (21) est conçue comme une piste sinueuse à courbe multiple (39).

6. Unité de commande selon la revendication 5,
**caractérisée en ce que** la piste conductrice (36) de la résistance de freinage (21) a une forme de méandre.

7. Unité de commande selon l'une des revendications 1 à 6,
**caractérisée en ce que** la piste conductrice (36) de la résistance de freinage (21) n'est formée que sur une face plate (14, 15) de la platine (30).

8. Unité de commande selon l'une des revendications 1 à 7,
**caractérisée en ce que** la platine (30) de l'unité de commande (3) est scellée avec une masse de scellement (41), et la piste conductrice (36) de la résistance de freinage (21) est directement en contact conducteur de chaleur avec la masse de scellement (41).

9. Unité de commande selon l'une des revendications 1 à 8,
**caractérisée en ce que** le commutateur de frein (22) est disposé sur la platine (30).

10. Unité de commande selon l'une des revendications 1 à 9,
**caractérisée en ce que** la platine (30) se compose d'un matériau composite en résine époxy et d'un tissu en fibres de verre.

11. Unité de commande selon l'une des revendications 1 à 10,
**caractérisée en ce que** la masse de scellement (41) se compose d'un polyuréthanne.
